# EUROPEAN PATENT SPECIFICATION

(11) **EP 2 020 454 B1**
(45) Date of publication and mention of the grant of the patent: **05.09.2012**
(21) Application number: 07014814.3
(22) Date of filing: 27.07.2007
(51) Int. Cl.: C23C 14/56, C23C 14/22, C23C 14/24, C23C 14/12

(54) **Evaporation apparatus with inclined crucible**
Verdampfungsvorrichtung mit geneigtem Tiegel
Appareil d'évaporation doté d'un creuset incliné

(43) Date of publication of application: 04.02.2009
(73) Proprietor: Applied Materials, Inc., Santa Clara, CA 95054 (US)
(72) Inventor: Buschbeck, Wolfgang, 63454 Hanau (DE); König, Michael, 60529 Frankfurt am Main (DE); Keller, Stefan, 63814 Mainaschaff (DE); Bangert, Stefan, 36396 Steinau (DE)
(74) Representative: Zimmermann, Gerd Heinrich

(56) References cited:
- WO-A-2004/063419
- WO-A-2006/037516
- DE-C1- 19 545 914
- GB-A- 964 461
- US-A- 2 969 448
- US-A- 2 996 412
- US-A- 3 020 177
- US-A1- 2004 221 802
- US-A1- 2005 103 273

## Description

### FIELD OF THE INVENTION

The invention generally relates to thin-film forming apparatuses and crucibles used in an evaporation apparatus for thin film forming. Particularly, it relates to an evaporation apparatus for evaporation of alloys or metals, and an evaporation method. More specifically, it relates to an evaporation apparatus, and a method of use thereof for use in the production of organic light emitting diodes.

### BACKGROUND OF THE INVENTION

For thin-film coating of a material on a substrate, a thermal evaporator can be used. For example, coatings with metal films, which e.g. provide a capacitor of a large panel display or a protective layer on a flexible substrate or web, can be applied with evaporators. Evaporators are known, e.g. from documents GB 964 461, US 3 020 177, US 2 969 448 and US 2 996 412.

In particular, organic evaporators are an essential tool for certain production types of organic light-emitting diodes (OLED). OLEDs are a special type of light-emitting diodes in which the emissive layer comprises a thin-film of certain organic compounds. Such systems can be used in television screens, computer displays, portable system screens, and so on. OLEDs can also be used for general room illumination. The range of colours, brightness, and viewing angle possible with OLED displays are greater than that of traditional LCD displays because OLED pixels directly emit light and do not require a back light. Therefore, the energy consumption of OLED display is considerably less than that of traditional LCD displays. Further, the fact that OLEDs can be coated onto flexible substrates opens the door to new applications such as roll-up displays or even displays embedded in clothing.

In general, the stack of emissive layers and conductive layers of an OLED is sandwiched by electrodes. The functionality of an OLED depends, inter alias, on the coating thickness of the electrodes. In the production of OLEDs it is therefore important, that the coating rate, at which the coating with electrode material is effected, lies within a predetermined tolerance range. It is generally desirable that the coating thickness is as uniform as possible. Moreover, when coating the substrate with material such as a metal, the layers already deposited on the substrate, in particular the organic materials, shall not be damaged by side effects of the evaporation process such as plasma radiation. Specifically the organic materials are more sensitive to damages than the non-organic materials used in conventional evaporation processes. So-called flash evaporators have been used in the coating of organic materials so far but do not provide a solution to a continuous coating process.

### SUMMARY OF THE INVENTION

In light of the above, the present invention provides an evaporation apparatus according to claim 1 and a method for evaporating according to claim 16. Preferred embodiments of the invention are disclosed in dependent Claims 2 to 15 and 17 to 24.

According to an aspect of the present invention, an evaporation apparatus for depositing material on a vertically oriented substrate is provided with at least one evaporation crucible, wherein the evaporation crucible has an evaporation surface for evaporating the material with the evaporation surface being inclined at an inclination angle in relation to the horizontal.

According to another aspect of the present invention, a method is provided that comprises providing a vertically oriented substrate; providing a crucible having an evaporation surface for evaporating material; and evaporating the material on the evaporation surface that is inclined at an inclination angle in relation to the horizontal.

Typical inclination angles are between 10° and 90° and even more typically between 60° and 90°.

Further advantages, features, aspects and details that can be combined with the above embodiments are evident from the dependent claims, the description and the drawings.

Embodiments are also directed to apparatuses for carrying out the disclosed methods and including apparatus parts for performing each described method steps.

### BRIEF DESCRIPTION OF THE DRAWINGS

Some of the above indicated and other more detailed aspects of the invention will be described in the following description and partially illustrated with reference to the figures. Therein:

Figure 1A shows a schematic view of a crucible having a recess for use in an evaporation apparatus according to the present invention.

Figure 1B is a schematic view of another embodiment of a crucible with planar surface for use in an evaporation apparatus according to the present invention.

Figures 2A, 2B, 2C and 3 show various embodiments of the evaporation apparatus according to the present invention.

Figure 4 shows the inclination geometry of a possible crucible usable with the evaporation apparatus according to the present invention.

Figure 5A and 5B show embodiments of the evaporation apparatus according to the present invention with a multitude of crucibles positioned above each other.

Figure 6A and 6B show embodiments of the evaporation apparatus according to the present invention with a multitude of crucibles positioned horizontally next to each other.

Figures 7A, 7B, and 7C show embodiments of inclined crucibles for the evaporation apparatus according to the present invention.

### DETAILED DESCRIPTION OF THE DRAWINGS

Without limiting the scope of the present application, in the following aluminum is described as a material to be deposited on a substrate. The invention is still directed to metals, alloys or other materials to be evaporated and used for coating of a substrate. Further, without limiting the scope of the present invention, a substrate is typically referred to as a glass substrate as often used for display technology, e.g., displays. Embodiments of the present invention can be applied to thin-film vapor deposition on other substrates and for other technologies, e.g., for flexible substrates or webs. In particular, embodiments of the present invention can be used in OLED production. Typically, the evaporation apparatus according to the present invention is for coating a substrate that has already been coated with organic material or that is still to be coated with organic material. That is, the substrate may be organic light emitting diodes in production.

Within the following description of the drawings, the same reference numbers refer to the same components. Generally, only the differences with respect to the individual embodiments are described.

Typically, the material to be evaporated is evaporated thermally in the embodiments of the present invention.

In general, and in particularly for large panel displays, a substrate, which e.g. can be provided as a large and relatively thin glass plate, is typically vertically positioned in a coating process and coated with a vertical evaporator. The term "relatively thin" in this context refers to typical glass thicknesses of between 0.5 mm and 4.0 mm, typically between 0.5 mm and 1.2 mm such as between 0.5 mm and 0.7 mm or between 0.7 mm and 1.2 mm. The term "vertical evaporator" shall be defmed as an evaporator arranged and adapted for coating a vertically oriented substrate. Further, the term "substrate" shall also include films and the like. The substrates that are processed according to the present invention may already be coated with organic material.

Vertical evaporation as taught by the present invention allows for the continuous in-line production of coated substrates, such as OLEDs. More particularly, vertical evaporation allows the coating of large substrates and the effective preventing of particles on the substrate. Generally, the present invention allows the coating of substrates having arbitrary length and height. In typical embodiments, one evaporator is provided per 30-40 cm height of the substrate. Height in this context refers to the vertical dimension of the substrate as positioned in the evaporation apparatus. For instance, a substrate with a height of 80 cm can be evaporated with an evaporation apparatus having two or three vertical evaporators.

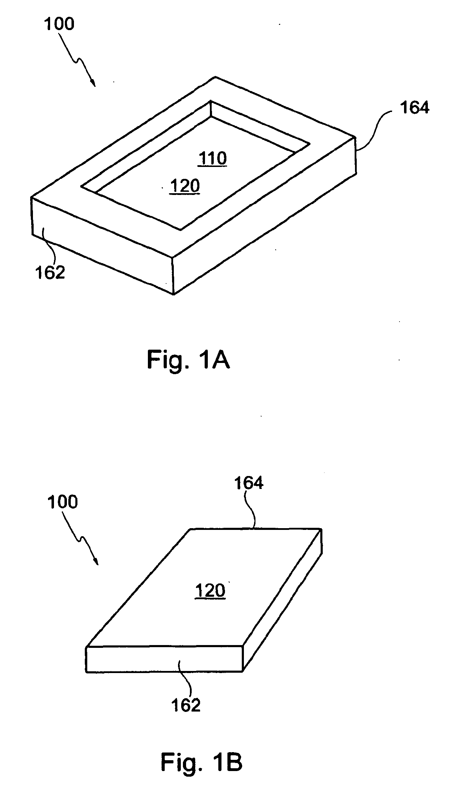

Fig. 1A and 1B show a schematic side view of two crucibles 100 as usable for the evaporation apparatus of the present invention. The crucible as shown in Fig. 1A provides for a recess area 110 in the middle of the crucible with reference number 120 referring to the evaporation surface whereas the crucible of Fig. 1B is planar. Alternatively, the crucible could comprise an elevation. The use of crucibles with different geometries is also possible. For instance, the cross-section of the crucible may be of a triangular, trapezoid, or round shape. In the following, for the sake of simplicity, the crucible will be depicted having a planar form, i.e. a rectangular cross-section. However, this shall be understood as referring to other crucible shapes as well.

In operation, as will be described in more detail below, the crucible 100 enables thin film forming of a material on a substrate. According to typical embodiments described herein, the material to be vapor deposited on the substrate can be a metal like aluminum, gold, copper, or alloys including at least one of these metals.

Generally, according to embodiments described herein, the material of the crucible is conductive. Typically, the material used is temperature resistant to the temperatures used for melting and evaporating. In general, the material of the crucible is resistant with regard to the material that is evaporated and/or the material that is generated in the evaporation process. For instance, aluminum is highly reactive and can cause significant damages to the crucible if an inadequate material of the crucible is chosen.

Typically, the crucible of the present invention is made of one ore more materials selected from the group consisting of metallic boride, metallic nitride, metallic carbide, non-metallic boride, non-metallic nitride, non-metallic carbide, nitrides, titanium nitride, borides, graphite, TiB2, BN, B₄C, and SiC. Typical lengths of the crucible are in the range of 90 mm and 350 mm, more typically between 90 mm and 180 mm such as 130 mm whereas typical widths of the crucible are in the range of 20 mm and 40 mm such as 30 mm. Typical heights of the crucible are in the range of 5 mm and 15 mm such as 10 mm.

The material to be deposited is melted and evaporated by heating the evaporation crucible 100. Heating can be conducted by providing a power source (not shown) connected to the first electrical connection 162 and the second electrical connection 164. For instance, these electrical connections may be electrodes made of copper or an alloy thereof. Thereby, heating is conducted by the current flowing through the body of the crucible 100. According to other embodiments, heating may also be conducted by an irradiation heater of an evaporation apparatus or an inductive heating unit of an evaporation apparatus.

The temperature on the crucible surface is typically chosen to be in the range of 1300°C to 1600°C, e.g., about 1560°C. This is done by adjusting the current through the crucible accordingly, or by adjusting the irradiation accordingly. Typically, the crucible material is chosen such that its stability is not negatively affected by temperatures of that range.

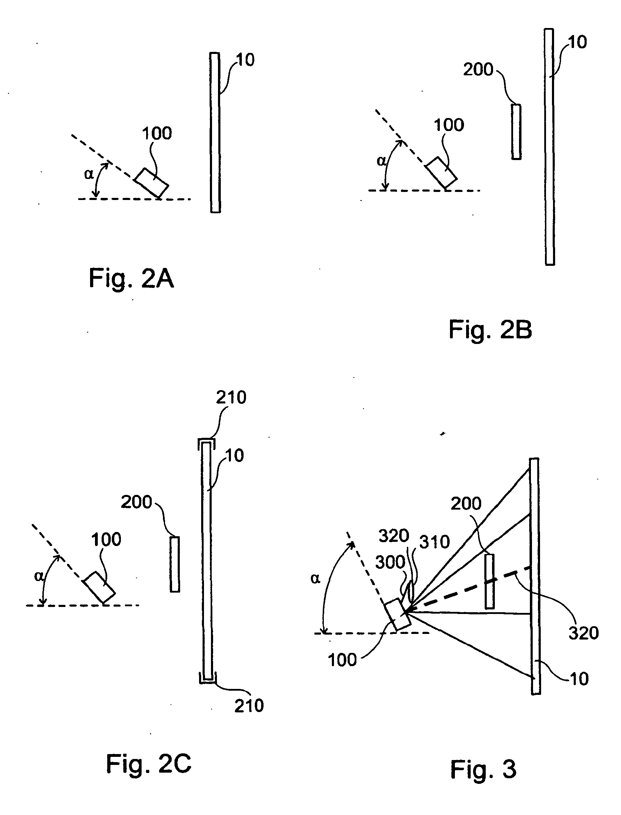

As shown in Fig. 2A, in typical embodiments of the present invention, the evaporator crucible 100 is used for vertical evaporation, i.e. with the substrate 10 being vertically arranged. According to typical embodiments of the vertical evaporator according to the present invention, the substrate 10 travels horizontally past the evaporator crucible 100. Thereby, the evaporation apparatus according to the present invention provides a continuous coating process of the vertically arranged substrate in the horizontal direction. This continuous coating shall be called "in-line coating" within the present application.

As a further example, an evaporation crucible 100 is provided in front of a vertically arranged substrate 10. Between the evaporation crucible 100 and the substrate 10 a mask 200 is positioned. The mask helps in further avoiding undesired irregularities in the coating thickness. Typical mask sizes are in the range of 50 mm and 200 mm. Typical mask shapes are curved. Typically, the mask is symmetrical in the vertical direction. As shown in Fig. 2B, the mask is typically positioned such that the center of the evaporation distribution is suppressed. This is due to the fact that, in general, the coating on the substrate shall be as homogeneous as possible and the evaporation distribution is maximal in the center of the distribution.

In Fig. 2C, means 210 adapted for supporting the substrate 10 in a vertical orientation are shown. These means may be, for instance, means for transporting the substrate past the crucible, e.g. a conveyor belt, driven rollers or the like. The means for supporting the substrate may adhere to the substrate at several positions, e.g. at the bottom side and at the top side of the substrate. These means 210 are applicable in all embodiments of the present invention. During the evaporation process, the substrates are driven past the crucible while they are coated with the material. Typically, the speed of the substrates is in the range of between 20 cm/min and 200 cm/min, more typically between 80 cm/min and 120 cm/min such as 100 cm/min. In these cases, the means for transporting should be capable of transporting the substrate at those speeds.

As shown in Fig. 2A, 2B and 2C, the evaporation crucible 100 is positioned in front of a vertically arranged substrate 10. Depending on the distance of the evaporator crucible from the substrate, the size of the evaporation area on the substrate can be controlled.

As shown in the embodiments depicted in Fig. 2A, 2B, and 2C, the crucible is inclined to the horizontal. In the following Figures 2A-2C, 3, 4, and 5, the crucible is exemplarily shown as having a flat surface with the top surface being parallel to the bottom surface. Hence, in these cases, the inclination angle of the crucible is identical to the inclination angle of the evaporation surface of the crucible. Therefore, for the sake of simplicity, whenever appropriate, the phrase "the crucible is inclined" may be used instead of "the evaporation surface of the crucible is inclined". However, the person skilled in the art will understand that these examples may also refer to embodiments wherein solely the evaporation surface of the crucible is inclined. According to the present invention, the inclination angle α is between 10° and 90°, typically between 10° and 80°. In some embodiments of the present invention, the inclination angle α is between 45° and 90°, more typically between 60° and 90° or between 75° and 90°. The crucible may be mounted on a support that allows for adjusting the inclination angle manually or electrically. For instance, the support may be driven by an electromotor that is connected to a control such as an personal computer.

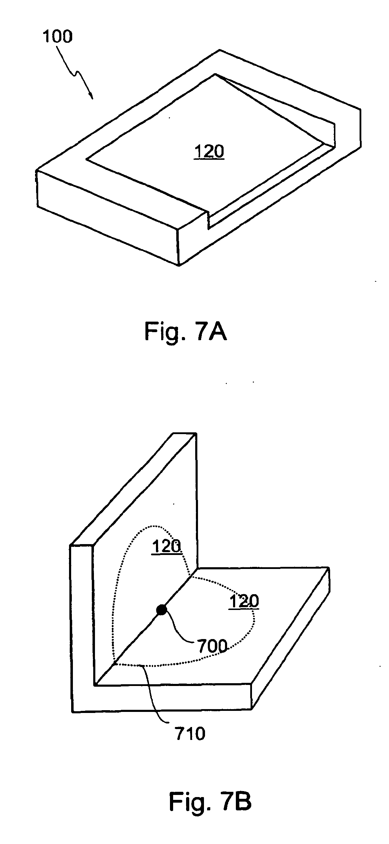

Typically, the crucible is inclined with respect to its width. The crucible extends along three dimensions. In general, the direction in which the crucible has the largest extension defines the direction of the length of the crucible. Analogously, the direction in which the crucible's extension is the smallest, defines the direction of the thickness of the crucible. The direction of the width of the crucible is defined as being perpendicular to the thickness direction and length direction. The inclination with respect to the crucible's width refers to the situation that different positions along the width of the crucible are spaced differently from the horizontal. The inclination with respect to the width can be effected by rotating the crucible along an axis that is parallel to the length direction of the crucible. Further, as will be more thoroughly described with respect to Figure 7A, the inclination of the evaporation side of the crucible can also be achieved by e.g. providing a crucible having a different thickness along its width.

In other embodiments, the crucible is inclined with respect to its length. The inclination with respect to the crucible's length refers to the situation that different positions along the length of the crucible are spaced differently from the horizontal. The inclination with respect to the length can be effected by rotating the crucible along an axis that is parallel to the width direction of the crucible.

In a typical method for evaporating, the material to be deposited, for example aluminum, is provided by continuously feeding the material with a feeding wire. In typical embodiments, the diameter of the feeding wire is chosen between 0.5 mm and 2.0 mm, more typically between 1.0 mm and 1.5 mm. The amount of material evaporated is provided by the diameter and the feeding speed of the feeding wire. According to a further embodiment, the wire can include a single element. In the case an alloy is to be deposited on the substrate, the wire can be provided with the material being an alloy. According to an even further embodiment, if an alloy is to be deposited on the substrate, several wires of the materials constituting the desired alloy can be provided to form the desired alloy. Thereby, the feeding speed of the wires can be adjusted to provide the desired alloy composition.

For instance, in the embodiment shown in Fig. 3 the material to be evaporated is fed to the crucible from the schematically shown coil 310 which is, in the perspective of Fig. 3, positioned behind the crucible. The evaporation apparatus according to the present invention may comprise a coil carrier 320 to which the coil 310 with the material to be deposited can be mounted. Further, the coil carrier typically comprises means for uncoiling the wire at a constant speed that can be set, for instance, by the operator of the evaporation apparatus. Typical feeding rates of the wire are in the range of between 50 cm/min and 150 cm/min, more typically between 70 cm/min and 100 cm/min. The wire 300 of the material to be deposited is uncoiled from the wire coil 310 and fed to the crucible 100 via the front or back side of the crucible where it is evaporated.

The term "crucible" as used in the present application shall be understood as a unit capable of vaporizing material that is fed to the crucible when the crucible is heated. In other words, a crucible is defined as a unit adapted for transforming solid material into vapour. In typical embodiments of the present invention, the feeding rate at which the material is fed to the crucible and the temperature of the crucible are adjusted such that a substantial part of the solid material is directly transformed into material vapour. That is, the amount of liquid material on the crucible is very small in typical embodiments of the present invention. More particularly, it is typical that the liquid slowly disperses on the surface of the crucible in a distance in the range of 10 mm and 60 mm as seen from the point of feeding the wire to the crucible. However, the amount of liquid material is so small that the liquid can not freely flow and, in particular, does not flow due to gravity forces. The distribution of the material on the crucible is defined by the wetting behavior. Therefore, in typical embodiments of the present invention, the crucible may be inclined at high inclination angles α in relation to the horizontal even if the crucible use is planar without providing any recess for a liquid.

In typical embodiments of the present invention with one evaporator, when seen only in the vertical dimension, the crucible is positioned in the lower part of the substrate. That is, the crucible is typically positioned lower than the substrate's vertical center. For instance, the crucible is positioned between 50 and 150 mm below the substrate's vertical center. In other embodiments, the crucible is positioned between 0 and 150 mm, typically between 50 and 150 mm above the substrate's bottom. In embodiments of the present invention having two or more evaporators, the evaporators are typically positioned above each other. The height of the substrate to be coated is split into several sub-heights with one evaporator being allocated to each sub-height. Typically, one evaporator is provided for each 30-40 cm height of the substrate to be coated. In embodiments with several evaporators, each evaporator is typically located in the lower part of the respective sub-height such as between 50 and 150 mm below the sub-height's vertical center.

It is also typical that the crucible is vertically positioned above the substrate's bottom side. This is due to the fact that the typical inclination angles of the present invention, such as between 60° and 90°, result in an evaporation distribution whose average direction is oriented such that the vertical component of the direction leads upwards. This is exemplarily shown in Fig.3 where reference number 320 refers to the average direction of the evaporation distribution. As shown in the embodiment of Fig. 3, the mask unit 200 may be used for blocking the very off-axis part of the evaporation distribution. In typical embodiments, the evaporation distribution is not symmetrically due to the inclination and/or the shape of the crucible.

Typical inclination angles α are between 10° and 90°, more typically between 45° and 90°. In many embodiments of the present invention, the angle α is between 60° and 90°, even more typically between 75° and 90°. In many embodiments, higher angles result in a better efficiency. Further, analysis reveals that gravity does not have any influence on the wetting of the material on the crucible. Also the evaporation distribution is not affected by gravity forces. According to typical embodiments of the present invention, the crucible is inclined at an angle of about 90°. "About 90°" in this context shall refer to an angle of between 80° and 100°.

The inclination of the evaporation surface of the crucible in the space shall be defined as follows: Typically, the crucible has a surface to which the material is fed to and on which the material is evaporated. This surface shall be called evaporation surface and may be flat or structured. It is geometrically possible to construct the normal at every point of this surface. The normal at this point is defined as the straight line crossing the surface perpendicularly at this particular point. The average normal is defined as the average of all normals of the surface of the crucible. The plane being perpendicular to the average normal shall be defined as the orientation of the evaporation surface of the crucible. In other words, if the evaporation surface of the crucible is positioned horizontally this means that the average normal is perpendicular to the horizontal and that the plane perpendicular to the average normal lies in the horizontal. The feature "the evaporation surface of the crucible is inclined at 10° in relation to the horizontal" refers to the situation wherein the plane perpendicular to the average normal is inclined at 10° in relation to the horizontal. This can equally be expressed as the average normal being inclined at 10° in relation to the vertical.

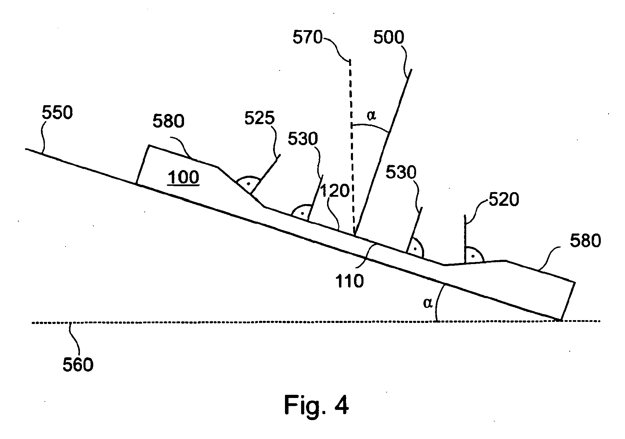

As an example, Fig. 4 shows a crucible 100 usable with the evaporation apparatus according to the present invention. The crucible has a recess area 110 that is symmetric. The recess area 110 of the crucible of Fig. 4 defines the evaporation surface 120 being surrounded by the crucible edge region 580. As it will be evident for the person skilled in the art, the crucible edge region is not meant for evaporating material. In operation, the edge region will not be wetted with the evaporation material. The crucible is inclined at an angle α in relation to the horizontal 560. This is the angle between plane 550 and horizontal. Some normals on the evaporation surface of the crucible are exemplarily depicted in Fig. 4: Normals 510 and 530 are inclined at an angle α in relation to the vertical. The normals 520 and 525 are the normals at the edge of the recess 110. The average normal of all those normals depicted and those not shown is the normal 500. The added vector resulting from a vectorially addition of the normals 520 and 525 points in the direction of the average normal 500. The normal 500 is inclined at an angle α in relation to the vertical 570. The average normal defines the plane 550 as the plane being perpendicular to the average normal.

Hence, the inclination angle shall be defined as the difference angle α of the average normal of the evaporation surface from the vertical direction. This is equivalent to a definition of the inclination angle as the difference angle α of the average surface orientation on the evaporation surface from the horizontal orientation. The evaporation surface is the surface of the crucible that is intended for evaporating the material. Typically, the evaporation surface does not include edge regions of the crucible that are not provided for contributing to the generation of the evaporation distribution.

Fig. 4 shall be understood as exemplarily showing the geometry of a crucible having an inclined evaporation surface in relation to its position in the space. In general, crucibles for use in the evaporation apparatus according to the present invention can have an arbitrary shape, in particular, may be symmetric or non-symmetric.

As an exemplary embodiment, a method of forming a thin film can be carried out by using an apparatus which is entirely placed in a vacuum chamber with a typical atmosphere of 10⁻² to 10⁻⁶ mbar. Thereby, the thin film can be vapor deposited on a substrate without contamination from the ambient atmosphere. In order to provide for a vacuum, the evaporator apparatus of the present invention is typically positioned in a vacuum chamber (not shown). The vacuum chamber is typically equipped with vacuum pumps (not shown) and/or tube outlets (not shown) for pumping the air out of the chamber.

As a further example, the embodiments described herein can be utilized for the coating of substrates for display technology or the like. Thereby, substrate size may be as follows. A typical glass substrate and, thereby, also a coating area can have dimensions of about 0.7 mm x 500 mm x 750 mm. Yet, the substrates that can be processed with the present invention can also have a size of about 1500 mm x 1850 mm or even larger such as 2500 mm.

As described above, for typical embodiments of the evaporation apparatus, the vertically arranged substrate is horizontally moved along the evaporation crucible. Thereby, the amount of material is integrated across the horizontal vapor distribution of the evaporation crucible.

Typically, the distance between mask and substrate is between 50 and 200 mm. The typical distance between crucible and substrate is between 200 and 600 mm, for instance between 350 and 450 mm. The typical distance between mask and crucible is between 200 and 400 mm.

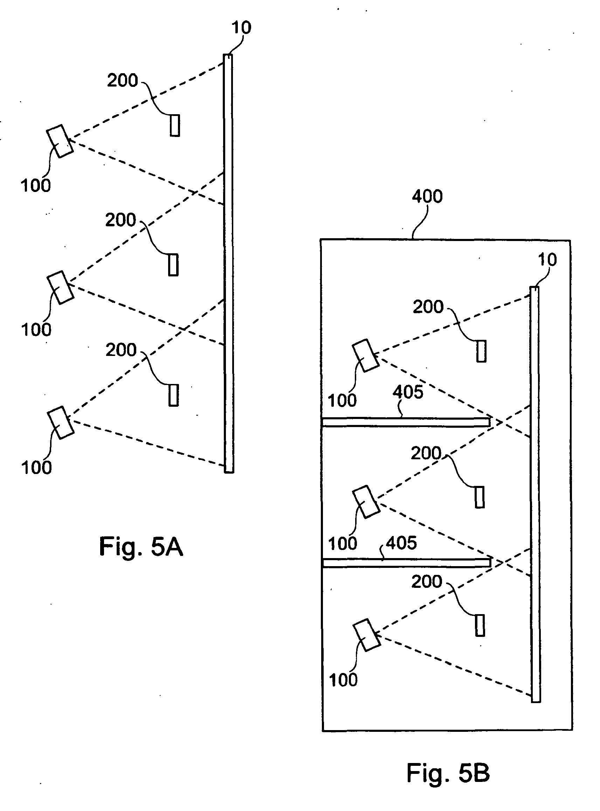

Fig. 5A shows an embodiment of an evaporation apparatus. Therein, three evaporation crucibles 100 are provided in front of a substrate 10. Between each of the crucibles and the substrate a respective mask 200 is provided. It is possible to position separation units 405 such as walls between the crucibles as shown in Fig. 5B. In general, the multitude of crucibles is positioned such that their respective evaporation distribution overlaps with the evaporation distribution of the adjacent crucible(s).

In a typical embodiment, each crucible is loaded with separate material wire. Typically, the wire for all crucibles is made of the same material. In the embodiments shown in Fig. 5A and 5B, coil carriers (not shown) can be provided for mounting the coils with the wires of material to be evaporated. Typically, the inclination angle of the several crucibles is identical.

In the embodiment shown in Fig. 5B, the vacuum chamber 400 is depicted within which the evaporation apparatus according to the present invention is located. It shall be understood that all embodiments of an evaporation apparatus discussed herein can be positioned within a vacuum chamber.

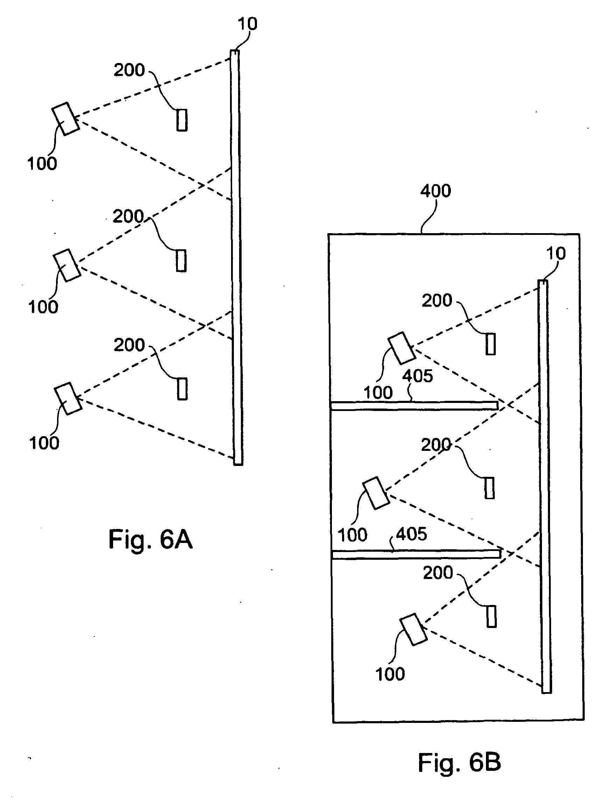

In another embodiment shown in Figs. 6A and 6B, the crucibles are arranged horizontally next to each other. Consequently, the evaporation distributions of the evaporation crucibles are provided next to each other, such that the substantially homogeneous coating of the substrate can be provided. According to one embodiment, each evaporation crucible is loaded with separate material wire.

According to the embodiment shown in Fig. 6B, crucibles 100 are positioned displaced to each other. That is, some of the crucibles are positioned closer to the substrate than other crucibles. Typical displacement distances are between 20 and 60 mm. Typically, the displacement distance is between 5% and 15% such as 10% of the distance between crucible and substrate. This interval is to be understood as referring to the distance between the crucible, which is furthest to the substrate, and the substrate minus the distance between the crucible, which is closest to the substrate, and the substrate.

In addition or alternatively, it is also possible (not shown) that the respective masks of each crucible are arranged displaced to each other. In general, the displacement of the crucibles and/or the masks may be alternating or following other logics. The displacement may improve the coating characteristics on the substrate. The positioning of the crucibles may be such that different average directions of the evaporation distributions are taken into account.

In the embodiments with several crucibles, it is possible that one common mask is used that has several apertures, e.g. each for one crucible.

Further, in embodiments with several crucibles the number of crucibles and the respective inclination angles are typically optimized in order to have the substrate coated as homogeneously as possible. Generally, the number of crucibles is chosen such that one crucible is assigned to each sub-height of the substrate. This can, for instance, result in a number of crucibles of between two and five. For example, a substrate with a height of 1100 mm, it is typical to provide 3-4 crucibles. As previously explained, the height of the substrate refers to the vertical dimension of the crucible as positioned in the vertical evaporation apparatus.

Figures 7A-7C show various embodiments of crucibles for the evaporation apparatus according to the present invention. The crucible 100 shown in Fig. 7A provides for an inclined evaporation surface 120. According to the definition given above, the average normal of the crucible of Fig. 7A is inclined with respect to the vertical direction. This is particularly true if the crucible's bottom is parallel to the horizontal plane. It is, however, also possible to additionally incline the crucible so that the inclination angle of the evaporation side is increased.

Fig. 7B shows another embodiment of a crucible for the evaporation apparatus according to the present invention. In Fig. 7B, the feeding point 700 is schematically shown. The feeding point 700 is the point on the evaporation surface 120 of the crucible on which the material wire is fed to the crucible in operation of the crucible. The material of the material wire is melted at the feeding point. As a consequence, the region 710 around the feeding point is wetted with the melted material. This is schematically shown in the drawing of Fig. 7B. The size of the region 710 depends on the feeding rate, the material, the temperature of the crucible and so on. However, the evaporation surface of the crucible 100 of Fig. 7B is both the horizontally oriented plane and the vertically oriented plane. In this regard, it is typical for the operation of the crucible that the distribution of the melted material on the crucible is not affected by gravity forces. The evaporation side of the crucible of Fig. 7B has an inclination angle of 45°.

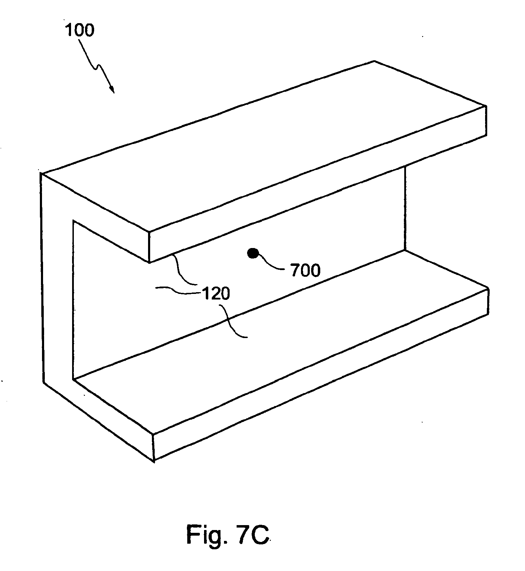

Fig. 7C shows another embodiment of the present invention with the crucible having a U-shape wherein the opening of the "U" is oriented horizontally. Typically, material is fed to the feeding point 700 on the vertically oriented evaporation side of the crucible. Depending on the crucible, in particular its detailed construction and material, the vertically oriented sides may additionally be used as evaporation surface. In this case, the evaporation material is melted at the feeding point 700. The vertically and horizontally oriented inner surface sides of the U-shaped crucible are wetted with the evaporation material in operation of the crucible.

Independent on whether the horizontally oriented inner surface sides of the U-shaped crucible are intended for evaporating material, the inclination angle of the crucible as shown in Fig. 7C is 90°.

The efficiency of an evaporation undertaken with the evaporation apparatus according to the present invention or the method for evaporating according to the present invention is typically between 4% and 10%, more typically between 6% and 10%. The efficiency in this context shall be understood as the amount of material coated on the substrate in relation to the total amount of material fed to the evaporator. Yields of this range are hardly known in the state of the art. In particular, the state of the art providing for a crucible that is oriented horizontally with the further provision of a heating plate serving as a reflector does not provide for evaporation efficiency in this magnitude. A high efficiency is advantageous in several aspects: Firstly, in particular in the event of precious metals, the costs of consumed material are reduced. Secondly, the higher the coating rate, the shorter the time necessary during that the substrates have to be exposed to the evaporation. Hence, the production time can be reduced. However, what is even more important in many embodiments of the present invention is that the higher the efficiency is, the lower the deposition rate on equipment of the evaporation apparatus. As cleaning of the evaporation apparatus equipment is a large issue, in particular with materials such as aluminum and the like, every improvement of the efficiency is desirable.

## Claims

1. Evaporation apparatus for depositing material on a substrate (10), the substrate being oriented vertically, the evaporation apparatus comprising:
at least one evaporation crucible (100), the evaporation crucible being a unit adapted for transforming solid material directly into vapor;
the evaporation crucible (100) having an evaporation surface (120) for evaporating the material (300);
wherein the evaporation surface is inclined at an inclination angle (α) in relation to the
horizontal; and
**characterised in that** the evaporation apparatus is adapted so that the vertically arranged substrate can be horizontally moved along the evaporation crucible.

2. Evaporation apparatus according to claim 1, wherein the inclination angle (α) is between 10° and 90°.

3. Evaporation apparatus according to claim 1, wherein the inclination angle (α) is between 60° and 90°.

4. Evaporation apparatus according to claim 1, wherein the inclination angle (α) is between 80° and 100°.

5. Evaporation apparatus according to any of the preceding claims, wherein the substrate comprises organic material.

6. Evaporation apparatus according to any of the preceding claims, wherein the evaporation surface of the crucible is substantially planar.

7. Evaporation apparatus according to any of the preceding claims, wherein the crucible comprises a recess (110) and/or an elevation on the evaporation side.

8. Evaporation apparatus according to any of the preceding claims, further comprising means (210) for transporting the vertically oriented substrate.

9. Evaporation apparatus according to claim 8, wherein the means (210) for transporting are arranged for continuously transporting the substrate.

10. Evaporation apparatus according to any of the preceding claims, further comprising a mask (200).

11. Evaporation apparatus according to any of the preceding claims, further comprising a coil carrier (320) for feeding a wire (300) of the material to be deposited to the crucible (100).

12. Evaporation apparatus according to any of the preceding claims, wherein the crucible further comprises electrodes (162, 164) for being connected to a current source.

13. Evaporation apparatus according to any of the preceding claims, wherein the crucible is made of one ore more materials selected from the group consisting of metallic boride, metallic nitride, titanium nitride, metallic carbide, non-metallic boride, non-metallic nitride, non-metallic carbide, nitrides, borides, graphite, TiB2, BN, B₄C, and SiC.

14. Evaporation apparatus according to any of the preceding claims comprising at least two crucibles positioned above each other.

15. Evaporation apparatus according to any of the preceding claims comprising at least two crucibles positioned next to each other in a horizontal direction.

16. Method for evaporating material on a substrate comprising:
- providing a vertically oriented substrate (10);
- providing a crucible having an evaporation surface (120) for evaporating a material , the evaporation crucible being a unit adapted for transforming solid material directly into vapor;
- evaporating the material on the evaporation surface (120) that is inclined at an inclination angle (α) in relation to the horizontal;
- moving the vertically arranged substrate horizontally along the evaporation crucible; and
- adjusting the temperature of the crucible as well as the feeding rate at which the material is fed to the crucible.

17. Method according to claim 16, further comprising feeding a wire (300) of the material to the crucible.

18. Method according to claim 16 or 17 wherein the material is fed at a rate in the range of 50 cm/min and 150 cm/min.

19. Method according to any of claims 16 to 18, wherein evaporating is undertaken continuously in an in-line production.

20. Method according to any of claims 16 to 19, wherein the method is for producing an organic light emitting diode.

21. Method according to any of claims 16 to 20, wherein the crucible is inclined at an angle (α) of between 10° and 90°.

22. Method according to any of claims 16 to 20, wherein the crucible is inclined at an angle (α) of between 60° and 90°.

23. Method according to any of claims 16 to 21, wherein the crucible is inclined at an angle (α) of 80° and 100°.

24. Method according to any of claims 16 to 23, wherein the crucible is heated to a temperature of between 1300°C and 1600°C.

## Patentansprüche

1. Verdampfungsvorrichtung zum Abscheiden eines Stoffs auf einem Substrat (10), wobei das Substrat vertikal ausgerichtet ist, wobei die Verdampfungsvorrichtung umfasst:
mindestens einen Verdampfungstiegel (100), wobei es sich bei dem Verdampfungstiegel um eine Einheit handelt, die dazu ausgelegt ist, einen Feststoff direkt in Dampf umzuwandeln;
wobei der Verdampfungstiegel (100) eine Verdampfungsfläche (120) zum Verdampfen des Stoffs (300) aufweist;
wobei die Verdampfungsfläche in einem Neigungswinkel (α) in Bezug auf die Horizontale geneigt ist; und
**dadurch gekennzeichnet, dass**
die Verdampfungsvorrichtung so ausgelegt ist, dass das vertikal angeordnete Substrat horizontal entlang des Verdampfungstiegels bewegt werden kann.

2. Verdampfungsvorrichtung nach Anspruch 1, wobei der Neigungswinkel (α) zwischen 10 ° und 90 ° beträgt.

3. Verdampfungsvorrichtung nach Anspruch 1, wobei der Neigungswinkel (α) zwischen 60 ° und 90 ° beträgt.

4. Verdampfungsvorrichtung nach Anspruch 1, wobei der Neigungswinkel (α) zwischen 80 ° und 100 ° beträgt.

5. Verdampfungsvorrichtung nach einem der vorhergehenden Ansprüche, wobei das Substrat einen organischen Stoff umfasst.

6. Verdampfungsvorrichtung nach einem der vorhergehenden Ansprüche, wobei die Verdampfungsfläche des Tiegels im Wesentlichen plan ist.

7. Verdampfungsvorrichtung nach einem der vorhergehenden Ansprüche, wobei der Tiegel eine Vertiefung (110) und/oder eine Erhebung auf der Verdampfungsseite umfasst.

8. Verdampfungsvorrichtung nach einem der vorhergehenden Ansprüche, darüber hinaus Einrichtungen (210) zum Transportieren des vertikal ausgerichteten Substrats umfassend.

9. Verdampfungsvorrichtung nach Anspruch 8, wobei die Einrichtungen (210) zum Transportieren zum kontinuierlichen Transportieren des Substrats eingerichtet sind.

10. Verdampfungsvorrichtung nach einem der vorhergehenden Ansprüche, darüber hinaus eine Maske (200) umfassend.

11. Verdampfungsvorrichtung nach einem der vorhergehenden Ansprüche, darüber hinaus einen Spulenträger (320) zum Zuführen eines Drahts (300) des abzuscheidenden Stoffs zum Tiegel (100) umfassend.

12. Verdampfungsvorrichtung nach einem der vorhergehenden Ansprüche, wobei der Tiegel darüber hinaus Elektroden (162, 164) umfasst, um an eine Stromquelle angeschlossen zu sein.

13. Verdampfungsvorrichtung nach einem der vorhergehenden Ansprüche, wobei der Tiegel aus einem oder mehreren Material/ien hergestellt ist, das/die aus der Gruppe ausgewählt ist/sind, die aus metallischem Borid, metallischem Nitrid, Titannitrid, metallischem Carbid, nicht-metallischem Borid, nicht-metallischem Nitrid, nicht-metallischen Carbid, Nitriden, Boriden, Graphit, TiB₂, BN, B₄C und SiC besteht.

14. Verdampfungsvorrichtung nach einem der vorhergehenden Ansprüche, mindestens zwei übereinander angeordnete Tiegel umfassend.

15. Verdampfungsvorrichtung nach einem der vorhergehenden Ansprüche, mindestens zwei in einer horizontalen Richtung nebeneinander angeordnete Tiegel umfassend.

16. Verfahren zum Aufdampfen eines Stoffs auf ein Substrat, Folgendes umfassend:
- Bereitstellen eines vertikal ausgerichteten Substrats (10);
- Bereitstellen eines Tiegels mit einer Verdampfungsfläche (120) zum Verdampfen eines Stoffs, wobei es sich bei dem Verdampfungstiegel um eine Einheit handelt, die dazu ausgelegt ist, einen Feststoff direkt in Dampf zu verwandeln;
- Verdampfen des Stoffs auf der Verdampfungsfläche (120), die in einem Neigungswinkel (α) in Bezug auf die Horizontale geneigt ist;
- Bewegen des vertikal angeordneten Substrats horizontal entlang des Verdampfungstiegels; und
- Einstellen der Temperatur des Tiegels sowie der Zuführrate, mit der der Stoff dem Tiegel zugeführt wird.

17. Verfahren nach Anspruch 16, darüber hinaus umfassend, einen Draht (300) des Stoffs dem Tiegel zuzuführen.

18. Verfahren nach Anspruch 16 oder 17, wobei der Stoff mit einer Rate im Bereich von 50 cm/min und 150 cm/min zugeführt wird.

19. Verfahren nach einem der Ansprüche 16 bis 18, wobei das Verdampfen kontinuierlich in einer Reihenfertigung erfolgt.

20. Verfahren nach einem der Ansprüche 16 bis 19, wobei das Verfahren zur Fertigung einer organischen lichtemittierenden Diode bestimmt ist.

21. Verfahren nach einem der Ansprüche 16 bis 20, wobei der Tiegel in einem Winkel (α) zwischen 10° und 90° geneigt ist.

22. Verfahren nach einem der Ansprüche 16 bis 20, wobei der Tiegel in einem Winkel (α) zwischen 60° und 90° geneigt ist.

23. Verfahren nach einem der Ansprüche 16 bis 21, wobei der Tiegel in einem Winkel (α) zwischen 80° und 100° geneigt ist.

24. Verfahren nach einem der Ansprüche 16 bis 23, wobei der Tiegel auf eine Temperatur zwischen 1300 °C und 1600°C erhitzt wird.

## Revendications

1. Appareil d'évaporation destiné à déposer de la matière sur un substrat (10), le substrat étant orienté verticalement, l'appareil d'évaporation comprenant :
au moins un creuset d'évaporation (100), le creuset d'évaporation étant une unité apte à transformer de la matière solide directement en vapeur;
le creuset d'évaporation (100) ayant une surface d'évaporation (120) destinée à évaporer la matière (300) ;
dans lequel la surface d'évaporation est inclinée à un angle d'inclinaison (α) par rapport à l'horizontale; et
**caractérisé en ce que**
l'appareil d'évaporation est adapté de telle manière que le substrat disposé verticalement puisse être déplacé horizontalement le long du creuset d'évaporation.

2. Appareil d'évaporation selon la revendication 1, dans lequel l'angle d'inclinaison (α) est compris entre 10° et 90°.

3. Appareil d'évaporation selon la revendication 1, dans lequel l'angle d'inclinaison (α) est compris entre 60° et 90°.

4. Appareil d'évaporation selon la revendication 1, dans lequel l'angle d'inclinaison (α) est compris entre 80 ° et 100°.

5. Appareil d'évaporation selon l'une quelconque des revendications précédentes, dans lequel le substrat comprend de la matière organique.

6. Appareil d'évaporation selon l'une quelconque des revendications précédentes, dans lequel la surface d'évaporation du creuset est essentiellement plane.

7. Appareil d'évaporation selon l'une quelconque des revendications précédentes, dans lequel le creuset comprend un évidement (110) et/ou une élévation du côté de l'évaporation.

8. Appareil d'évaporation selon l'une quelconque des revendications précédentes, comprenant en outre des moyens (210) de transport du substrat orienté verticalement.

9. Appareil d'évaporation selon la revendication 8, dans lequel les moyens (210) de transport sont disposés pour le transport continu du substrat.

10. Appareil d'évaporation selon l'une quelconque des revendications précédentes, comprenant en outre un masque (200).

11. Appareil d'évaporation selon l'une quelconque des revendications précédentes, comprenant en outre un porte-bobine (320) destiné à amener un fil (300) de la matière à déposer au creuset (100).

12. Appareil d'évaporation selon l'une quelconque des revendications précédentes, dans lequel le creuset comprend en outre des électrodes (162, 164) destinées à être raccordées à une source de courant.

13. Appareil d'évaporation selon l'une quelconque des revendications précédentes, dans lequel le creuset est constitué d'une ou de plusieurs matières sélectionnées dans le groupe constitué par le borure métallique, le nitrure métallique, le nitrure de titane, le carbure métallique, le borure non métallique, le nitrure non métallique, le carbure non métallique, les nitrures, les borures, le graphite, TiB₂, BN, B₄C, et SiC.

14. Appareil d'évaporation selon l'une quelconque des revendications précédentes, comprenant au moins deux creusets positionnés l'un au-dessus de l'autre.

15. Appareil d'évaporation selon l'une quelconque des revendications précédentes, comprenant au moins deux creusets positionnés l'un à côté de l'autre en sens horizontal.

16. Procédé d'évaporation de matière sur un substrat, comprenant :
- mettre en place un substrat (10) orienté verticalement;
- mettre en place un creuset ayant une surface d'évaporation (120) destinée à évaporer une matière, le creuset d'évaporation étant une unité apte à transformer de la matière solide directement en vapeur;
- évaporer de la matière sur la surface d'évaporation (120) qui est inclinée à un angle d'inclinaison (α) par rapport à l'horizontale;
- déplacer horizontalement le substrat orienté verticalement, le long du creuset d'évaporation; et
- régler la température du creuset ainsi que de la cadence d'amenée à laquelle la matière est amenée au creuset.

17. Procédé selon la revendication 16, comprenant en outre amener un fil (300) de la matière au creuset.

18. Procédé selon la revendication 16 ou 17, dans lequel la matière est amenée à une cadence comprise entre 50 cm/min et 150 cm/min.

19. Procédé selon l'une quelconque des revendications 16 à 18, dans lequel l'évaporation est réalisée en continu dans une production en ligne.

20. Procédé selon l'une quelconque des revendications 16 à 19, dans lequel le procédé est destiné à produire une diode luminescente organique.

21. Procédé selon l'une quelconque des revendications 16 à 20, dans lequel le creuset est incliné à un angle (α) compris entre 10° et 90°.

22. Procédé selon l'une quelconque des revendications 16 à 20, dans lequel le creuset est incliné à un angle (α) compris entre 60° et 90°.

23. Procédé selon l'une quelconque des revendications 16 à 21, dans lequel le creuset est incliné à un angle (α) compris entre 80° et 100°.

24. Procédé selon l'une quelconque des revendications 16 à 23, dans lequel le creuset est chauffé à une température comprise entre 1300°C et 1600°C.
